# EUROPEAN PATENT APPLICATION

(11) **EP 3 358 638 A1**
(43) Date of publication of application: **08.08.2018**
(21) Application number: 17813551.3
(22) Date of filing: 13.06.2017
(51) Int. Cl.: H01L 51/44, H01L 51/00, H01L 51/42, C08L 65/00, C08L 25/18

(54) **ORGANIC SOLAR CELL AND METHOD FOR MANUFACTURING SAME**

(30) Priority: 15.06.2016 KR 20160074401; 23.06.2016 KR 20160078484
(71) Applicant: Kolon Industries, Inc., Gwacheon-si, Gyeonggi-do 13837 (KR)
(72) Inventor: CHO, Geun Sang, Yongin-si Gyeonggi-do 16910 (KR); KU, Ja-Ram, Yongin-si Gyeonggi-do 16910 (KR); MOON, Jeong Yeol, Yongin-si Gyeonggi-do 16910 (KR); PARK, Hong Kwan, Yongin-si Gyeonggi-do 16910 (KR); CHOI, Yoon Young, Yongin-si Gyeonggi-do 16910 (KR)
(74) Representative: Ter Meer Steinmeister & Partner
(86) International application number: PCT/KR2017/006119
(87) International publication number: WO 2017/217727

(57) **Abstract**

The present invention relates to an organic solar cell, and a method for manufacturing same, and in particular, to an organic solar cell comprising a substrate; a negative electrode formed on the substrate; a photoactive layer formed on the negative electrode; and an integrated positive electrode formed on the photoactive layer, and including a hole transport material and a conductive nanowire.

The organic solar cell may exhibit excellent life time, performance and light transmittance, and may be used in a roll-to-roll process through coating, and accordingly, productivity and production efficiency of the organic solar cell may be improved.

## Description

### [Technical Field]

This application claims the benefits of Korean Patent Application No. 10-2016-0074401, filed on June 15, 2016, with the Korean Intellectual Property Office and Korean Patent Application No. 10-2016-0078484, filed on June 23, 2016, with the Korean Intellectual Property Office, the disclosure of which are herein incorporated by reference in their entirety.

The present invention relates to an organic solar cell having an excellent life time property and light transmittance, and a method for manufacturing same.

### [Background Art]

Generally, a solar cell is a photoelectric cell manufactured for the purpose of converting solar energy to electric energy, and means a semiconductor device transforming light energy produced from the sun to electric energy. Such a solar cell pollutes less, has an infinite resource and has a semi-permanent life time, and is expected as an energy source capable of resolving future energy problems. As for recent technologies on solar cells, studies on low-price solar cells lowering costs of power generation and studies on high efficiency solar cells increasing conversion efficiency have been progressed at the same time.

Solar cells are divided into inorganic solar cells and organic solar cells depending on materials forming a photoactive layer among internal components. As an inorganic solar cell, single crystal silicon is normally used, and such a single crystal silicon-based solar cell is excellent in terms of efficiency and stability, and provides most of the solar cells currently mass produced, but currently has limits in securing raw materials, enhancing efficiency and developing technologies for low-price products. In view of the above, an organic solar cell uses organic materials such as organic semiconductor materials of small molecules (also expressed as monomolecules) or polymers, and these organic materials are significantly low-priced compared to inorganic materials used in the inorganic solar cell, and are readily supplied since these may be diversely synthesized and processed. Accordingly, manufacturing process may be simplified and faster, and interests and studies on organic solar cells have intensified since applications to various materials and forms, and mass production may be achieved.

An organic solar cell basically has a thin film-type structure, and is generally formed with a positive electrode and a negative electrode located facing each other, and a photoactive layer located between the positive electrode and the negative electrode and including organic materials formed with a hole acceptor such as a conjugated polymer and an electron acceptor such as fullerene in a junctional structure. And as necessary, a hole transfer layer and an electron transfer layer may be further included at above and below the photoactive layer, respectively.

An organic device having such a multilayer thin film structure may be manufactured using various coating methods such as slot die coating, spin coating or gravure coating, and among these, a slot die coating method in a roll-to-roll mode is normally used.

As described above, the organic solar cell is capable of being mass produced due to simple processibility and low price, and has an advantage of being manufactured to a large-area electronic device having flexibility since it is capable of being manufactured to a thin film using a roll-to-roll method.

However, despite such technological and economic advantages, the organic solar cell is difficult to commercialize because the materials forming an organic solar cell are vulnerable to impurities, moisture, oxygen or ultraviolet rays, which shortens life time. Accordingly, various methods have been studied to enhance the life time of an organic solar cell such as adding a separate layer including a material capable of blocking the life time degradation, or replacing a metal electrode with a metal hardly oxidizable.

As one example, Korean Patent Application Publication No. 2011-0128122 discloses a method for enhancing efficiency and life time of an organic solar cell by using a metal oxide composite film including carbon nanotubes as an electron transfer layer.

In addition, Korean Patent Application Publication No. 2012-0018043 discloses a method for improving a problem of life time decrease of an organic solar cell by providing a zinc oxide thin film having excellent conductivity and transparency on a transparent electrode as a buffer layer.

These patents have somewhat improved a life time of an organic solar cell, however, the effects are not sufficient, and adding a separate material or layer causes property decline of an organic solar cell, and is uneconomical since it requires long hours and high costs in terms of a process. Accordingly, development of an organic solar cell having excellent life time and efficiency has been increasingly required.

### [Prior Art Documents]

### (Patent Documents)

Korean Patent Application Publication No. 2011-0128122 (2011.11.28), A carbon nanotube embedded metal oxide composite film, the method for preparation of carbon nanotube embedded metal oxide composite film and organic solar cell with improved light to electric energy conversion efficiency and life-time using the same

Korean Patent Application Publication No. 2012-0018043 (2012.02.29), Method for manufacturing high efficiency conductive ZnO thin film, inverted structure organic solar cell having the same and method for manufacturing the organic solar cell

### [Disclosure]

### [Technical Problem]

As a result of extensive studies in view of the above, the inventors of the present invention have identified that preparing an integrated positive electrode including a hole transport material and a conductive nanowire may increase a life time and efficiency of an organic solar cell, and is readily used in a roll-to-roll process. In addition, the inventors of the present invention have identified that using a specific compound as an electron acceptor in a photoactive layer of the organic solar cell may secure light transmittance at a certain level or higher in the organic solar cell, and have completed the present invention.

Accordingly, an aspect of the present invention provides an organic solar cell having excellent life time, performance and light transmittance.

Another aspect of the present invention provides a method for manufacturing the organic solar cell.

### [Technical Solution]

According to an aspect of the present invention, there is provided an organic solar cell comprising a substrate; a negative electrode formed on the substrate; a photoactive layer formed on the negative electrode; and an integrated positive electrode formed on the photoactive layer, and including a hole transport material and a conductive nanowire.

The integrated positive electrode comprises the conductive nanowire in a matrix including the hole transport material to form a three-dimensional network structure.

The integrated positive electrode has a thickness of from 0.1 µm to 5 µm.

The hole transport material includes at least one selected from the group consisting of poly(3,4-ethylenedioxythiophene) and poly(styrene sulfonate).

The conductive nanowire includes at least one selected from the group consisting of metal-based nanowires and carbon-based nanowires.

The photoactive layer includes a fullerene-based compound as an electron acceptor.

The organic solar cell has light transmittance of 40% or greater.

A retroreflective layer is further comprised on the integrated positive electrode.

A metal oxide thin film layer is further comprised between the negative electrode and the photoactive layer.

According to another aspect of the present invention, there is provided a method for manufacturing an organic solar cell comprising preparing a substrate; forming a negative electrode on the substrate; forming a photoactive layer on the negative electrode; and forming an integrated positive electrode including a hole transport material and a conductive material on the photoactive layer.

The integrated positive electrode is formed by coating in a roll-to-roll method on the photoactive layer of using a composition including the hole transport material and the conductive material, and then curing the composition.

Forming a metal oxide thin film layer on the negative electrode is further comprised prior to the forming of a photoactive layer on the negative electrode.

### [Advantageous Effects]

By introducing an integrated positive electrode including a hole transport material and a conductive nanowire, an organic solar cell according to the present invention is capable of preventing life time property decline of a conventional organic solar cell that have metal electrodes, and, by forming two layers into one layer, the organic solar cell may be manufactured in a thin film form. In addition thereto, the organic solar cell enhances light transmittance of the cell by including a specific electron acceptor in a photoactive layer.

In addition, the organic solar cell can be readily used in a roll-to-roll process, and this improves production quantities and production efficiency in the manufacture of the organic solar cell, and enables mass production.

### [Description of Drawings]

FIG. 1 is a diagram schematically illustrating a structure of an existing organic solar cell.
FIG. 2 is a diagram schematically illustrating a structure of an organic solar cell according to one embodiment of the present invention.
FIG. 3 is a diagram schematically illustrating a structure of an organic solar cell according to another embodiment of the present invention.
FIG. 4 is a diagram schematically illustrating a structure of an organic solar cell according to still another embodiment of the present invention.

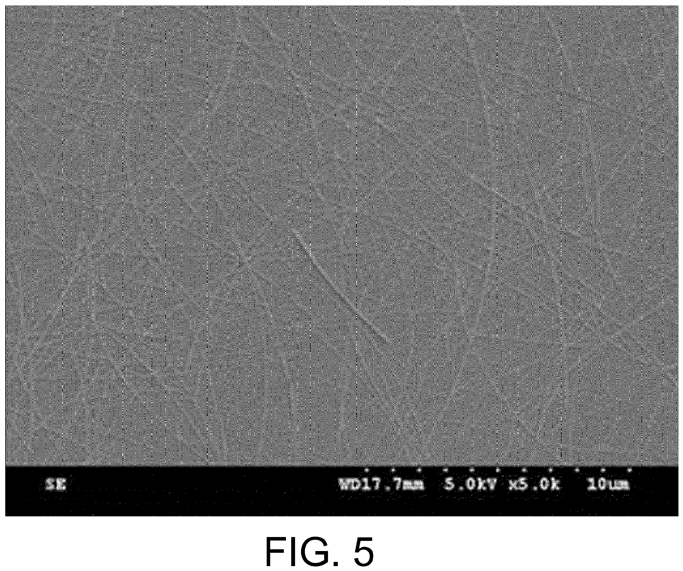

FIG. 5 is a scanning electron microscope (SEM) image of an integrated positive electrode formed in Example 1 of the present invention.

### [Best Mode]

Hereinafter, embodiments of the present invention will be described in detail with reference to accompanying drawings so that those skilled in the art may readily implement the present invention. However, the present invention may be implemented in various different forms, and is not limited to the embodiments described herein. In addition, like reference numerals designate like constituents in the drawings, and a size or a thicknesse of each constituent may be exaggerated for the convenience of description.

In the present specification, a description of a certain member being placed "on" another member includes not only a case of the one member adjoining the another member but a case of still another member being present between the two members.

In the present specification, a description of a certain part "including" certain constituents means capable of further including other constituents, and does not exclude other constituents unless particularly stated on the contrary.

The present invention provides an organic solar cell having enhanced life time property and light transmittance.

Compared to silicon-based inorganic solar cells that are high-price and have limits in the deposits, organic material-based organic solar cells have recently received attention based on advantages such as economic feasibility, process readiness, and the possibility of flexible device manufacturing due to a low temperature process. Particularly, organic solar cells using an organic semiconductor are very advantageous in terms of costs and processes since vacuum deposition is not required, and a solution process such as spin coating, dip coating or doctor blading may be used in the manufacturing. Processes such as roll-to-roll have been recently introduced with a view to commercializing such an organic solar cell, however, much changes are required to be actually used in organic solar cell manufacturing.

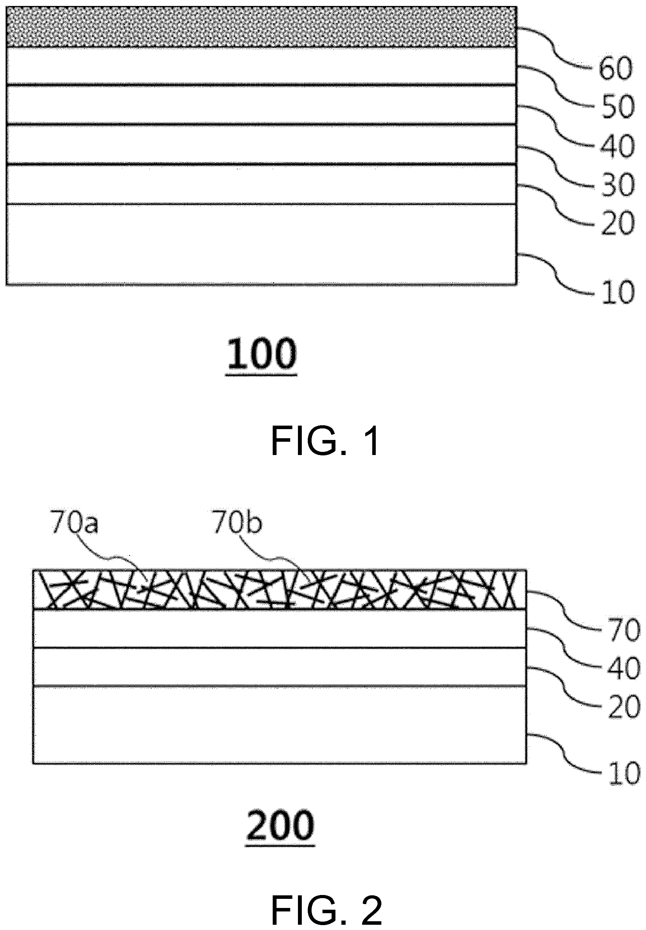

As illustrated in FIG. 1, a conventional organic solar cell (100) has a structure in which a negative electrode (20), a metal oxide thin film layer (30), a photoactive layer (40), a hole transport layer (50) and a positive electrode (60) are laminated on a substrate (10) as constituents, and the constituents are formed using various coating methods such as spin coating, dip coating or gravure coating.

However, the positive electrode of the conventional organic solar cell generally uses a silver (Ag) paste as a metal electrode. Herein, a residual solvent and impurities included in the silver paste are diffused to layers present at a lower part when driving a cell, particularly, to a photoactive layer, and this reduces a life time of the organic solar cell by degradation as well as damaging organic materials forming the photoactive layer, and decreases light transmittance. In addition, the metal electrode formed by the silver paste is difficult to form through a coating process, and therefore, methods such as screen printing, gravure printing, gravure-offset printing, thermal vapor deposition, electron beam deposition, RF or magnetron sputtering, or chemical deposition are used. Such methods are not suitable to be introduced in a roll-to-roll process.

In view of the above, the present invention provides an organic solar cell comprising a negative electrode and a positive electrode located on a substrate facing each other, and an organic layer including a photoactive layer between the negative electrode and the positive electrode, wherein the positive electrode is formed to an integrated positive electrode including a hole transport material and a conductive nanowire. As a result, performance, a life time and light transmittance of the organic solar cell may be enhanced by preventing damage and degradation on the lower layers caused by residual solvent and impurities when using a paste.

In addition, the integrated positive electrode may be formed through a coating process, and is readily used in a roll-to-roll process, which is advantageous in enhancing productivity and commercialization of the organic solar cell.

FIG. 2 is a diagram schematically illustrating a structure of an organic solar cell according to one embodiment of the present invention.

When referring to FIG. 2, an organic solar cell (200) according to one embodiment of the present invention comprises a substrate (10); a negative electrode (20) formed on the substrate; a photoactive layer (40) formed on the negative electrode; and an integrated positive electrode (70) formed on the photoactive layer, and including a hole transport material (70a) and a conductive nanowire (70b).

The substrate (10) is not particularly limited as long as it has transparency.

As one example, the substrate (10) may be a transparent inorganic substrate such as quartz or glass, or one type of a transparent plastic substrate selected from the group consisting of polyethylene terephthalate (PET), polyethylene naphthalate (PEN), polycarbonate (PC), polystyrene (PS), polypropylene (PP), polyimide (PI), polyethylene sulfonate (PES), polyoxymethylene (POM), polyetherehterketone (PEEK), polyethersulfone (PES) and polyetherimide (PEI) may be used. Among these, a film-type transparent plastic substrate having high chemical stability, mechanical strength and transparency while being flexible is preferred.

In addition, the substrate (10) may have transmittance of at least 70% or greater and preferably 80% or greater in a visible wavelength of approximately 400 nm to 750 nm.

The thickness of the substrate is not particularly limited, and may be properly determined depending on the applications, and as one example, the thickness may be from 1 µm to 500 µm.

The negative electrode (20) is formed on the substrate (10) described above, and becomes a path enabling light passing through the substrate (10) to reach a photoactive layer (40), and therefore, using a conductive material having high transparency, high work function of approximately 4.5 eV or greater and low resistance is preferred.

As one example, as the negative electrode (20), metal oxide transparent electrodes selected from the group consisting of indium tin oxide (ITO), indium zinc oxide (IZO), fluorine-doped tin oxide (FTO), ZnO-Ga₂O₃, ZnO-Al₂O₃, SnO₂-Sb₂O₃ and combinations thereof; organic transparent electrodes such as conductive polymers, graphene thin films, graphene oxide thin films or carbon nanotube thin films; organic-inorganic combined transparent electrodes such as metal-binding carbon nanotube thin films, or the like, may be used.

The negative electrode (20) may have a thickness of from 10 nm to 3000 nm.

The photoactive layer (40) is located on the negative electrode (20) described above, and has a bulk heterojunction structure mixing a hole acceptor and an electron acceptor.

The hole acceptor includes an organic semiconductor such as an electroconductive polymer or an organic low molecular semiconductor material. The electroconductive polymer may be at least one selected from the group consisting of polythiophene, polyphenylene vinylene, polyfluorene, polypyrrole and copolymers thereof. The organic low molecular semiconductor material may include at least one selected from the group consisting of pentacene, anthracene, tetracene, perylene, oligothiophene and derivatives thereof.

The hole acceptor may preferably include at least one selected from the group consisting of poly-3-hexylthiophene (P3HT), poly-3-octylthiophene (P3OT), poly-p-phenylene vinylene (PPV), poly(9,9'-dioctylfluorene), poly(2-methoxy-5-(2-ethyl-hexyloxy)-1,4-phenylenevinylene (MEH-PPV) and poly(2-methyl-5-(3',7'-dimethyloctyloxy))-1,4-phenylene vinylene (MDMOPPV).

The electron acceptor may include at least one selected from the group consisting of fullerene (C₆₀), fullerene-based compounds such as C₇₀, C₇₆, C₇₈, C₈₀, C₈₂ or C₈₄, CdS, CdSe, CdTe and ZnSe.

The electron acceptor preferably includes a fullerene-based compound, and specifically, may include at least one selected from the group consisting of fullerene (C₆₀), (6,6)-phenyl-C₆₁-butyric acid methyl ester (PCBM), (6,6)-phenyl-C₆₁-butyric acid-cholesteryl ester (PCBCR), (6,6)-phenyl-C₇₁-butyric acid methyl ester (C₇₀-PCBM) and (6,6)-thienyl-C₆₁-butyric acid methyl ester (ThCBM).

More preferably, the electron acceptor may be at least one selected from the group consisting of PCBM, C₇₀-PCBM and ThCBM, and even more preferably, be PCBM or C₇₀-PCBM. In the present invention, when using PCBM as the electron acceptor in the photoactive layer (40), the formed photoactive layer has higher transmittance in a visible region compared to other fullerene-based compounds, which is more advantageous in securing light transmittance of an organic solar cell.

Accordingly, the semi-transparent organic solar cell (200) of present invention may have light transmittance of 40% or greater and enhance transparency by using a fullerene-based compound as an electron acceptor in the photoactive layer (40), and also being provided with an integrated positive electrode (70) to describe later. Particularly, the organic solar cell exhibits excellent photoelectric conversion efficiency while having high transmittance in a visible region, and therefore, has an advantage of being used in building windows, roofs and the like.

At this time, the photoactive layer (40) more preferably includes a mixture of P3HT as a hole acceptor and PCBM as an electron acceptor, and a mixing weight ratio of the P3HT and the PCBM may be from 1:0.1 to 1:2.

The photoactive layer (40) may have a thickness of from 5 nm to 2000 nm, preferably from 10 nm to 500 nm and more preferably from 150 nm to 300 nm. When the thickness of the photoactive layer (40) is less than the above-mentioned range, sunlight is not sufficiently absorbed lowering a photoelectric current, and thereby causing an efficiency decrease, and when the thickness is greater than the above-mentioned range, electrons and holes inside may not migrate toward an electrode causing an efficiency decrease problem.

The integrated positive electrode (70) is formed on the photoactive layer (40) described above, and, by including a hole transport material (70a) and a conductive nanowire (70b), performs a role of a hole transfer layer of an existing solar cell as well. Specifically, by using a conductive nanowire instead of a conventional metal paste for forming a positive electrode, problems caused by a solvent and impurities that the paste contains do not occur, which increases a life time of an organic solar cell. In addition, since the conductive nanowire and the hole transport material are dispersed in a solution, a roll-to-roll process may be used as well as using a coating method. In addition, the integrated positive electrode (70) is a monolayer and performs a role of both a conventional hole transfer layer and positive electrode, and therefore, an organic solar cell may be manufactured to a thin film, and an advantage of decreasing the number of lamination is also obtained in terms of process.

In addition thereto, the conductive nanowire (70b) forms a three-dimensional network structure inside a matrix including the hole transport material (70a) in the integral positive electrode (70), and is linked to each other making hole migration smoother, and as a result, photoelectric conversion efficiency of an organic solar cell may be enhanced.

The hole transport material (70a) serves to facilitate hole transfer and is dispersible into water together with a conductive nanowire to describe later. The hole transport material (70a) may include at least one selected from the group consisting of poly(3,4-ethylenedioxythiophene (PEDOT) and poly(styrene sulfonate) (PSS). Preferably, a mixture of the PEDOT and the PSS may be included.

The conductive nanowire (70b) performs a role of a positive electrode of an organic solar cell, and may include at least one selected from the group consisting of metal-based nanowires and carbon-based nanowires.

As the metal-based nanowire capable of being used in the present invention, common metal-based nanowires may be used without particular limit. As one example, the metal-based nanowire may be formed with one or more types of metal elements selected from the group consisting of gold (Au), silver (Ag), platinum (Pt), copper (Cu), nickel (Ni), iron (Fe), palladium (Pd), rhodium (Rh), iridium (Ir), cobalt (Co), tin (Sn), zinc (Zn) and molybdenum (Mo), and preferably, may be formed with silver (Ag).

The carbon-based nanowire capable of being used in the present invention may include at least one selected from the group consisting of carbon nanotubes, carbon nanofibers and graphene, and may be preferably carbon nanotubes.

The shape of the conductive nanowire (70b) is not particularly limited, and may be properly selected in accordance with the purposes, and examples thereof may include any shape such as a cylindrical shape, a rectangular shape or a column shape having a polygonal cross section. An average length of the major axis of the conductive nanowire (70b) is 1 µm or greater, preferably 5 µm or greater and more preferably 10 µm or greater, for example, from 1 µm to 1000 µm and specifically from 5 µm to 100 µm. When the conductive nanowire (70b) has a length of less than 1 µm, junctions between the nanowires are reduced causing a concern of increasing resistance. In addition, an average length of the minor axis (diameter) of the conductive nanowire (70b) is from 1 nm to 200 nm, preferably from 5 nm to 100 nm and more preferably from 10 nm to 50 nm. The diameter of the nanowire being too small may cause a concern of declining heat resistance of the nanowire, and when the diameter is too large, haze increases due to scattering causing a concern of reducing ray transmittance and visibility of the integrated positive electrode (70) containing the conductive nanowire (70b).

The content of the conductive nanowire (70b) in the integrated positive electrode (70) is not particularly limited, however, the content being too high is not preferred for dispersibility and light transmittance. Accordingly, the content of the conductive nanowire (70b) may be from 0.1% by weight to 10% by weight, and preferably from 1% by weight to 10% by weight. When the content of the conductive nanowire (70b) is less than the above-mentioned range, functions as an electrode may not be performed, and when the content is greater than the above-mentioned range, the content of PEDOT:PSS, the hole transport material, relatively decreases as well as greatly reducing dispersibility and light transmittance, and this also causes a problem of decreasing photoelectric conversion efficiency, and therefore, the content is properly used within the above-mentioned range.

The integrated positive electrode (70) may have a thickness of from 0.1 µm to 5 µm. In the conventional organic solar cell, a hole transfer layer is formed to a thickness of from 0.1 µm to 10 µm, and a positive electrode is formed to a thickness of from 5 µm to 20 µm. In comparison, the thickness of the integrated positive electrode (70) of the present invention is from 0.1 µm to 5 µm and preferably from 0.1 µm to 2 µm, which may significantly reduce a thickness of a final organic solar cell.

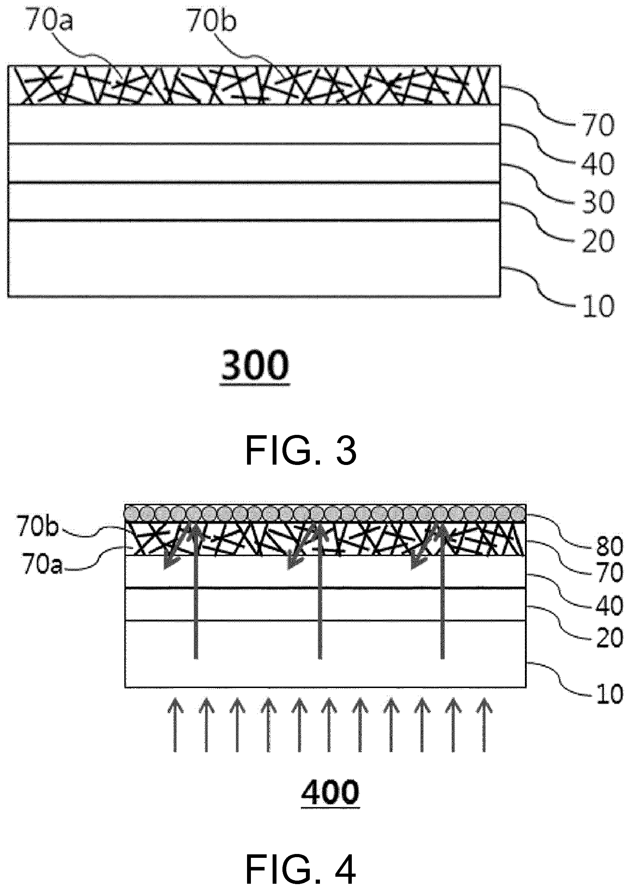

FIG. 3 is a diagram schematically illustrating a structure of an organic solar cell according to another embodiment of the present invention.

When referring to FIG. 3, the organic solar cell (300) according to another embodiment of the present invention additionally comprises a metal oxide thin film layer (30) between the negative electrode (20) and the photoactive layer (40) of the organic solar cell (200) of FIG. 2.

The metal oxide thin film layer (30) serves to increase efficiency of an organic solar cell by increasing an electron migration rate as an auxiliary electrode. In addition, affecting the photoactive layer (40) may be prevented by blocking oxygen and moisture inflowing from the outside.

The metal oxide thin film layer (30) may include at least one types of metal oxides selected from the group consisting of titanium (Ti), zinc (Zn), silicon (Si), manganese (Mn), strontium (Sr), indium (In), barium (Ba), potassium (K), niobium (Nb), iron (Fe), tantalum (Ta), tungsten (W), bismuth (Bi), nickel (Ni), copper (Cu), molybdenum (Mo), cerium (Ce), platinum (Pt), silver (Ag) and rhodium (Rh). The metal oxide thin film layer (30) is preferably formed with zinc oxide (ZnO) having a large band gap and semiconductive properties.

In addition, an average particle diameter of the metal oxides included in the metal oxide thin film layer (30) is 10 nm or less, preferably from 1 nm to 8 nm, and more preferably from 3 nm to 7 nm.

The substrate (10), the negative electrode (20), the photoactive layer (40) and the integrated positive electrode (70) of the organic solar cell (300) according to another embodiment of the present invention are the same as described in one embodiment of the present invention.

FIG. 4 is a diagram schematically illustrating a structure of an organic solar cell according to still another embodiment of the present invention.

When referring to FIG. 4, the organic solar cell (400) according to still another embodiment of the present invention additionally comprises a retroreflective layer (80) on the integrated positive electrode (70) in the organic solar cell (200) of FIG. 2.

The retroreflective layer (80) includes reflective beads having a certain shape, and reflects light transmitted through the positive electrode of an organic solar cell and allows the light to re-enter to the photoactive layer (40), and therefore, may increase photoelectric conversion efficiency.

As illustrated in FIG. 4, light (arrow) entering through the substrate (10) of the organic solar cell of the present invention is partially absorbed into the photoactive layer (40), and progressed to the integrated positive electrode (70), and herein, by forming the retroreflective layer (80) on the integrated positive electrode (70), the transmitted light is reflected and concentrated on the photoactive layer (40) enhancing efficiency of the organic solar cell.

At this time, the reflective beads having the same shape inside the retroreflective layer (80) may be arranged in a monolayer, a bilayer or a tri-layer, and may be preferably formed in a monolayer structure. In addition, the shape of the reflective bead is not particularly limited, and examples thereof may include a globular shape, an oval shape, a polyhedron, a twisted globular shape, a twisted oval shape, a twisted polyhedron shape, and the like.

The retroreflective layer (80) may be formed with reflective beads, and although the reflective bead is not particularly limited as long as it is transparent, the reflective bead may be an inorganic bead or an organic bead.

The inorganic bead may include at least one selected from the group consisting of silicon oxide, titanium oxide, aluminum oxide, tin oxide, indium oxide, ITO, zinc oxide, zirconium oxide, magnesium oxide, calcium carbonate, talc, clay, baked kaolin, baked calcium silicate, hydrated calcium silicate, aluminum silicate, magnesium silicate, calcium phosphate and the like.

The organic bead may include at least one selected from the group consisting of polyolefin-based, polyester-based, polyamide-based, polyimide-based, acrylic styrene-based, silicone-based, polystyrene-based, benzoguanamine-based, melamine-based, polyfluoroethylene-based, polymethacrylic acid methyl acrylate, polymethyl methacrylate, polycarbonate and the like.

The reflective beads preferably have a high refractive index with a refractive index of from 1.7 to 2.3. When the refractive index of the reflective beads corresponds to the above-mentioned range, high focal reflectivity is obtained by forming a focus on the inner wall of the reflector resultantly leading to high retroreflectance. When the refractive index is outside the above-mentioned range and less than 1.7, it is not preferred since focal reflectivity decreases resultantly decreasing retroreflectance.

In addition, the reflective beads may have an average particle diameter of from 10 µm to 100 µm, and preferably from 20 µm to 50 µm. Reflection efficiency may be most effectively obtained within the above-mentioned range.

The retroreflective layer (80) may have a thickness of from 10 µm to 300 µm. The thickness of the retroreflective layer (80) may vary depending on the type of the substrate and the application of the fabric, but specifically, may be a maximum particle diameter or greater of the reflective beads, and may preferably be 3 times or less of an average particle diameter of the reflective beads. When the thickness is less than the above-mentioned thickness range, a coating process is difficult to apply and the surface is not uniform when the retroreflective layer thickness is less than the maximum particle diameter of the reflective beads, and the thickness being greater than the above-mentioned thickness range may cause a concern of a refractive index decrease.

The substrate (10), the negative electrode (20), the photoactive layer (40) and the integrated positive electrode (70) of the organic solar cell (400) according to still another embodiment of the present invention are the same as described in one embodiment of the present invention.

In addition, the present invention may provide a method for manufacturing the organic solar cell.

Hereinafter, the method for manufacturing the organic solar cell according to one embodiment of the present invention will be described in detail.

The method for manufacturing an organic solar cell according to one embodiment of the present invention comprises preparing a substrate; forming a negative electrode on the substrate; forming a photoactive layer on the negative electrode; and forming an integrated positive electrode including a hole transport material and a conductive material on the photoactive layer.

In addition, the method for manufacturing the organic solar cell may further comprise at least one or more of forming a metal oxide thin film layer prior to the forming of a photoactive layer on the negative electrode, or forming a retroreflective layer on the integrated positive electrode.

First, a substrate is prepared and a negative electrode is formed on the substrate. The negative electrode may be formed on the prepared substrate using common methods. Specifically, the negative electrode may be formed on one surface of the substrate through thermal vapor deposition, electron beam deposition, RF or magnetron sputtering, chemical deposition of a composition for forming a negative electrode, or using similar methods thereto.

Herein, prior to the forming of a negative electrode, the surface of the substrate may be selectively pretreated using any one method selected from the group consisting of an O2 plasma treatment method, UV/ozone washing, surface washing using an acid or alkali solution, a nitrogen plasma treatment method and corona discharge washing.

Next, forming a thin film layer by coating a coating solution while transferring the negative electrode-formed substrate in a roll-to-roll method is included. Herein, the thin film layer includes a photoactive layer and an integrated positive electrode, and additionally, may include at least one or more of a metal oxide thin film layer or a retroreflective layer.

The coating solution includes materials and solvents included in each thin film layer. Specifically, the coating solution may be a composition for forming a photoactive layer, a composition for forming an integrated positive electrode, a composition for forming a metal oxide thin film layer and a composition for forming a retroreflective layer.

When the forming of a thin film layer is a photoactive layer, a composition for forming the photoactive layer prepared by dissolving the electron acceptor and the hole acceptor described above in a solvent is coated to form a film.

The solvent is not particularly limited as long as it is capable of dissolving or dispersing an electron acceptor and a hole acceptor. As one example, the solvent may be water; an alcohol such as ethanol, methanol, propanol, isopropyl alcohol or butanol; or an organic solvent such as acetone, pentane, toluene, benzene, diethyl ether, methyl butyl ether, N-methyl pyrrolidone (NMP), tetrahydrofuran (THF), dimethylformamide (DMF), dimethyl acetamide (DMAC), dimethyl sulfoxide (DMSO), carbon tetrachloride, dichloromethane, dichloroethane, trichloroethylene, chloroform, chlorobenzene, dichlorobenzene, trichlorobenzene, cyclohexane, cyclopentanone, cyclohexanone, dioxane, terpineol or methyl ethyl ketone, or a mixture thereof, and it is preferred that the solvent is properly selected and used among the above-mentioned solvents depending on the types of subject materials when preparing the coating solution.

The solvent may be included in the residual amount in the coating solution, and preferably, may be included in 1% by weight to 95% by weight, based on the total weight of the coating solution. When the solvent content is greater than 95% by weight, target functions of the coating layer is difficult to obtain, and when the solvent content is less than 1% by weight, a thin film having a uniform thickness is difficult to form.

In addition, when the forming of a thin film layer is an integrated positive electrode, a composition for forming the integrated positive electrode prepared by dissolving the electron transport material and the conductive nanowire described above in water is coated to form a film.

In addition to the electron transport material and the conductive nanowire described above, the integrated positive electrode composition may selectively further include other additives such as a surfactant, a wetting agent, a viscosity modifier, an anticorrosive agent, an antifoaming agent or a reducing agent commonly used in the art.

As the surfactant, anionic surfactants such as sodium lauryl sulfate, nonionic surfactants such as nonyl phenoxypolyethoxyethanol or FSN, a product of Dupont, cationic surfactants such as lauryl benzyl ammonium chloride, or amphoteric surfactants such as lauryl betaine or coco betaine may be used.

As the wetting agent or wetting and dispersing agent, compounds such as polyethylene glycol, Surfynol series, a product of Air Products, or TEGO Wet series of Degussa may be used.

As the viscosity modifier, BYK series of BYK, Glide series of Degussa, EFKA 3000 series of EFKA, DSX series of Cognis, or the like may be used.

The reducing agent is for facilitating baking when heat treating the integrated positive electrode composition after coating, and specifically, hydrazine, acetic hydrazide, sodium or potassium borohydride, trisodium citrate, and amine compounds such as methyldiethanolamine or dimethylamine borane; metal salts such as ferrous chloride or iron lactate; hydrogen; hydrogen iodide; carbon monoxide; aldehyde compounds such as formaldehyde or acetaldehyde; organic compounds such as glucose, ascorbic acid, salicylic acid, tannic acid, pyrogallol or hydroquinone, and the like may be used.

Particularly, the integrated positive electrode composition preferably has proper viscosity considering processibility. Specifically, the integrated positive electrode composition favorably has viscosity of from 0.1 cps to 50 cps, preferably from 1 cps to 20 cps and more preferably from 2 cps to 15 cps. When the viscosity is less than the above-mentioned range, the thin film thickness is not sufficient after baking causing a concern of a conductivity decrease, and the viscosity being greater than the above-mentioned range has a disadvantage in that the composition may not be smoothly discharged. Accordingly, it is preferred to control the molecular weight and the content of the used constituents so that the integral positive electrode composition has proper viscosity.

In addition, when the forming of a thin film layer is a metal oxide thin film layer or a retroreflective layer, a composition including the above-described metal oxide or reflective beads, respectively, is coated to form a film.

When forming each of the thin film layers for the substrate, the rate of transferring the substrate in a roll-to-roll method may be from 0.01 m/min to 20 m/min, and preferably from 0.1 m/min to 5 m/min. The transferring rate may be used through optimization depending on the coating and drying rates of the thin film layer using a roll-to-roll device.

The coating may be carried out using common coating methods such as slot die coating, spin coating, gravure coating, spraying, spin coating, dip coating or doctor blading, and preferably, slot die coating may be carried out.

After coating the coating solution, a post-treatment process of drying or heat treatment may be selectively performed on the coated-substrate. The drying may be performed for 1 minute to 30 minutes at 50°C to 400°C and preferably at 70°C to 200°C through hot-air drying, NIR drying or UV drying.

As one example, for the photoactive layer, a post-treatment process of drying and heat treatment may be performed for 5 minutes to 145 minutes at 25°C to 150°C after the coating process. By properly controlling the drying process and the heat treatment process, a proper phase separation may be induced between the electron acceptor and the hole acceptor, and orientation of the electron acceptor may be induced. As for the heat treatment process, heat treatment effects may be insignificant when the temperature is lower than 25°C since mobility of the electron acceptor and the hole acceptor is low, and when the heat treatment temperature is higher than 150°C, performance may decline due to degradation of the electron acceptor. In addition, when the heat treatment time is less than 5 minutes, heat treatment effects may be insignificant since mobility of the electron acceptor and the hole acceptor is low, and when the heat treatment time is greater than 145 minutes, performance may decline due to degradation of the electron acceptor.

The thickness of the thin film layer formed using the method as above may be properly determined depending on the applications, and may be preferably from 10 nm to 10 µm and more preferably from 20 nm to 1 µm. When the thin film layer thickness is within the above-mentioned range, efficiency of a manufactured organic device is most excellent.

The method for manufacturing the organic solar cell including such steps has an advantage in that a lamination process that used to be performed twice in the prior art may be performed only once, since a hole transfer layer and a positive electrode are formed by integrating them instead of each forming a hole transfer layer and a positive electrode. In addition, a roll-to-roll process may be used, and a module of an organic solar cell may be manufactured just by slot die coating with other layers.

The organic solar cell according to the present invention may enhance a battery life time by using an integrated positive electrode, and by including a fullerene-based compound in a photoactive layer as an electron acceptor, light transmittance increases in a visible region, and a final cell may be obtained in a semi-transparent form with light transmittance of 40% or greater. In addition, a thin film form may be obtained by reducing an overall cell thickness while having equal or higher efficiency compared to existing organic solar cells, and since continuous production is possible, the organic solar cell may be used in various fields such as clothes, wrapping papers, outer walls, roofs, windows, glass for automobiles, small portable electronic devices or disposable batteries.

Hereinafter, examples of the present invention will be described in detail so that those skilled in the art may readily implement the present invention. However, the present invention may be implemented in various different forms, and is not limited to the examples described herein.

### Example 1 and Comparative Example 1: Manufacture of Organic Solar Cell

### [Example 1]

While transferring an ITO layer-formed substrate film in a roll-to-roll method, a ZnO-containing coating solution (prepared by mixing 247 mg of Zn(OAC)₂2H₂O, 126 mg of KOH and 1 ml of 1-butanol) was slot die coated in a stripe form on the ITO layer, and then the result was dried at 120°C to form a ZnO metal oxide thin film layer. In the slot die coating, the line speed was 12 mm/sec, the slot die height was 1300 µm, and the coating solution flow rate was 0.4 ml/min.

Subsequently, on the ZnO metal oxide thin film layer, a coating solution for forming a photoactive layer (prepared by mixing 15 mg of lisicon® SP001 (manufactured by Merck), 12 mg of lisicon® A-600 (manufactured by Merck) and 1 ml of 1,2-dichlorobenzene) was slot die coated, and the result was dried at 120°C to form a photoactive layer. In the slot die coating, the line speed was 12 mm/sec, the slot die height was 1500 µm, and the coating solution flow rate was 1.2 ml/min.

On the photoactive layer, a composition for forming an integrated positive electrode including PEDOT:PSS (Orgacon® EL-P 5010, manufactured by agfa) and a silver nanowire having a diameter of approximately 30 nm and a height to width ratio of 1000:1 in a weight ratio of 9:1 was slot die coated with a line speed of 5 mm/sec, a slot die height of 800 µm, and a coating solution flow rate of 3.0 ml/min, and the result was dried at 120°C to form an integrated positive electrode (thickness 700 nm), and as a result, an organic solar cell was manufactured.

### [Example 2]

An organic solar cell was manufactured in the same manner as in Example 1 except that the photoactive layer was formed to a thickness of 171 nm by spin coating the coating solution for forming a photoactive layer of Example 1 at a rate of 1000 rpm, and heat treating the result for 2 minutes at 70°C.

### [Example 3]

An organic solar cell was manufactured in the same manner as in Example 1 except that C₇₀-PCBM (PV-A700 (manufactured by Merck) was used instead of PCBM (lisicon® A-600 (manufactured by Merck)) as the electron acceptor in the coating solution for forming a photoactive layer, and the photoactive layer was formed to a thickness of 171 nm by spin coating the coating solution for forming a photoactive layer at a rate of 1000 rpm, and heat treating the result for 2 minutes at 70°C.

### [Comparative Example 1]

While transferring an ITO layer-formed substrate film in a roll-to-roll method, a ZnO-containing coating solution (prepared by mixing 247 mg of Zn(OAC)₂2H₂O, 126 mg of KOH and 1 ml of 1-butanol) was slot die coated in a stripe form on the ITO layer, and then the result was dried at 120°C to form a ZnO metal oxide thin film layer. In the slot die coating, the line speed was 12 mm/sec, the slot die height was 1300 µm, and the coating solution flow rate was 0.4 ml/min.

Subsequently, on the ZnO metal oxide thin film layer, a coating solution for forming a photoactive layer (prepared by mixing 15 mg of lisicon® SP001 (manufactured by Merck), 12 mg of lisicon® A-600 (manufactured by Merck) and 1 ml of 1,2-dichlorobenzene) was slot die coated, and the result was dried at 120°C to form a photoactive layer. In the slot die coating, the line speed was 12 mm/sec, the slot die height was 1500 µm, and the coating solution flow rate was 1.2 ml/min.

On the photoactive layer, a composition for forming a hole transfer layer including PEDOT:PSS (Orgacon® EL-P 5010, manufactured by agfa) was slot die coated, and the result was dried at 120°C to form a hole transfer layer (thickness 700 nm). In the slot die coating, the line speed was 5 mm/sec, the slot die height was 800 µm, and the coating solution flow rate was 3.0 ml/min.

After that, an Ag electrode (thickness 10 µm) was printed on the hole transfer layer using a screen printer to manufacture an organic solar cell.

### [Comparative Example 2]

An organic solar cell was manufactured in the same manner as in Comparative Example 1 except that a composition for forming a hole transfer layer having the same composition as Comparative Example 1 was spin coated instead of forming the integral positive electrode on the photoactive layer, and the result was dried at 120°C to form a hole transport layer having a thickness of 40 nm, and then an Ag electrode having a thickness of 100 nm was deposited on the hole transport layer using an organic-inorganic depositor to form the positive electrode.

### Experimental Example 1: Performance Evaluation on Organic Solar Cell 1

Current-voltage properties of the organic solar cells manufactured in Example 1 and Comparative Example 1 were measured, and the results are shown in the following Table 1.

**[Table 1]**

| | Voc¹⁾ (V) | Jsc²⁾ (mA/cm²) | FF³⁾ (%) | Eff.⁴⁾ (%) |
|---|---|---|---|---|
| Example 1 | 0.76 | 10.25 | 51 | 4.02 |
| Comparative Example 1 | 0.78 | 12.09 | 65 | 6.10 |
| 1) Voc: Open-circuit voltage | | | | |
| 2) Jsc: Short-circuit photocurrent density | | | | |
| 3) FF: Fill factor | | | | |
| 4) Eff.: Efficiency (photoelectric conversion efficiency) | | | | |

When referring to Table 1, it was identified that the organic solar cell provided with the integrated positive electrode according to the present invention exhibited organic solar cell performance at a similar level with existing organic solar cells.

### Experimental Example 2: Performance Evaluation on Organic Solar Cell 2

Light transmittance and power conversion efficiency of the organic solar cells manufactured in Example 2, Example 3 and Comparative Example 2 were measured, and the results are shown in the following Table 1.

**[Table 2]**

| | Transmittance (%) | | PCE⁵⁾ (%) |
|---|---|---|---|
| | 550 nm | 380-780 nm | |
| Example 2 | 55.08 | 59.29 | 3.56 |
| Example 3 | 8.56 | 26.35 | 3.82 |
| Comparative Example 2 | 37.70 | 25.98 | 5.92 |
| 5) PCE: Power Conversion Efficiency | | | |

When referring to Table 2, it was identified that the organic solar cells of Examples 2 and 3 including a fullerene-based compound in a photoactive layer as an electron acceptor, and provided with an integrated positive electrode according to the present invention had similar power conversion efficiency compared to Comparative Example 2 forming each of a hole transport layer and a positive electrode while exhibiting higher light transmittance.

In Example 2 including PCBM as an electron acceptor, light transmittance in a visible region, particularly at 550 nm, increased by a maximum of 6 times or higher, and it was identified that organic solar cell performance was obtained at a similar level while enhancing transparency.

### [Reference Numeral]

10: Substrate
20: Negative Electrode
30: Metal Oxide Thin Film Layer
40: Photoactive Layer
50: Hole Transport Layer
60: Positive Electrode
70: Integrated Positive Electrode
70a: Hole Transport Material
70b: Conductive Nanowire
80: Retroreflective Layer
100, 200, 300, 400: Organic solar cell

### [Industrial Applicability]

The organic solar cell according to the present invention has excellent life time, performance and light transmittance, and is capable of being mass produced by simplifying a manufacturing process, and therefore, the organic solar cell may be used in various fields such as fashion outdoor goods, wrapping papers, wall papers, glass for automobiles as well as building exterior materials such as outer walls, roofs and windows.

## Claims

1. An organic solar cell comprising:
a substrate;
a negative electrode formed on the substrate;
a photoactive layer formed on the negative electrode; and
an integrated positive electrode formed on the photoactive layer, and including a hole transport material and a conductive nanowire.

2. The organic solar cell of Claim 1, wherein, the integrated positive electrode comprises the conductive nanowire in a matrix including the hole transport material to form a three-dimensional network structure.

3. The organic solar cell of Claim 1, wherein the integrated positive electrode has a thickness of from 0.1 µm to 5 µm.

4. The organic solar cell of Claim 1, wherein the hole transport material includes at least one selected from the group consisting of poly(3,4-ethylenedioxythiophene) and poly(styrene sulfonate).

5. The organic solar cell of Claim 1, wherein the conductive nanowire includes at least one selected from the group consisting of metal-based nanowires and carbon-based nanowires.

6. The organic solar cell of Claim 5, wherein the metal-based nanowire comprises at least one selected from the group consisting of gold, silver, platinum, copper, nickel, iron, palladium, rhodium, iridium, cobalt, tin, zinc and molybdenum.

7. The organic solar cell of Claim 5, wherein the carbon-based nanowire comprises at least one selected from the group consisting of carbon nanotubes, carbon nanofibers and graphene.

8. The organic solar cell of Claim 1, wherein the photoactive layer includes a fullerene-based compound as an electron acceptor.

9. The organic solar cell of Claim 1, wherein the organic solar cell has light transmittance of 40% or greater.

10. The organic solar cell of Claim 1, wherein the organic solar cell further comprises a retroreflective layer on the integrated positive electrode.

11. The organic solar cell of Claim 10, wherein the retroreflective layer includes reflective beads.

12. The organic solar cell of Claim 11, wherein the reflective beads have a refractive index of from 1.7 to 2.3.

13. The organic solar cell of Claim 11, wherein the reflective beads have an average particle diameter of from 10 µm to 100 µm.

14. The organic solar cell of Claim 10, wherein the retroreflective layer has a thickness of from 10 µm to 300 µm.

15. The organic solar cell of Claim 1, wherein the organic solar cell further comprises a metal oxide thin film layer between the negative electrode and the photoactive layer.

16. A method for manufacturing the organic solar cell of Claim 1, the method comprising:
preparing a substrate;
forming a negative electrode on the substrate;
forming a photoactive layer on the negative electrode; and
forming an integrated positive electrode including a hole transport material and a conductive material on the photoactive layer.

17. The method for manufacturing the organic solar cell of Claim 16, wherein the integrated positive electrode is formed by coating in a roll-to-roll method on the photoactive layer of using a composition including the hole transport material and the conductive material, and then curing the composition.

18. The method for manufacturing the organic solar cell of Claim 16, the method further comprises forming a metal oxide thin film layer on the negative electrode is further included prior to the forming of a photoactive layer on the negative electrode.
